# EUROPEAN PATENT APPLICATION

(11) **EP 4 583 403 A1**
(43) Date of publication of application: **09.07.2025**
(21) Application number: 23935902.9
(22) Date of filing: 22.11.2023
(51) Int. Cl.: H03H 17/02, H03M 1/08, H03M 1/12

(54) **DATA PROCESSING METHOD, SYSTEM, AND APPARATUS FOR MULTI-CHANNEL FILTER, DEVICE, AND MEDIUM**

(30) Priority: 13.11.2023 CN 202311511737
(71) Applicant: CRSC RESEARCH & DESIGN INSTITUTE GROUP CO., LTD., Fengtai District Beijing 100070 (CN)
(72) Inventor: LIU, Jiong, Beijing 100070 (CN); JIN, Xu, Beijing 100070 (CN); HUANG, Yao, Beijing 100070 (CN); LIN, Ziming, Beijing 100070 (CN); LIU, Guangyu, Beijing 100070 (CN)
(74) Representative: Haseltine Lake Kempner LLP
(86) International application number: PCT/CN2023/133101
(87) International publication number: WO 2025/102408

(57) **Abstract**

Embodiments of the present disclosure disclose a multi-channel filter data processing method, system, apparatus, device, and medium. The method includes: acquiring target data of multiple channels and corresponding filtering manners; storing the target data into corresponding registers, respectively, based on the filtering manners; herein a register corresponds to a filtering manner; determining whether a filter kernel corresponding to a register is in an idle state; and if the filter kernel is in the idle state, feeding the target data into the filter kernel to perform a filtering process. The present solution can effectively solve the problem of data loss by pre-storing the target data in a register and feeding the target data into different filter kernels according to the filtering manner.

## Description

### CROSS REFERENCES TO RELATED APPLICATIONS

This application claims priority to Chinese Patent Application No. 202311511737.5, filed November 13, 2023, the entire disclosure of which is hereby incorporated by reference.

### TECHNICAL FIELD

The present invention relates to the field of data processing, and more particularly, to a data processing method, system, apparatus, device, and medium for a multi-channel filter.

### BACKGROUND

A multi-channel synchronous sampling analog-to-digital data conversion system simultaneously samples multiple channels of data and transfers the multiple channels of data without interruption. These data introduce more or less noise during sampling or transmission, and are filtered before they are used.

A digital filter includes a plurality of multipliers, adders and delay elements, and some high-order digital filter has only one filter kernel due to the excessive resources occupied by the multipliers. Therefore, for a multi-channel digital filter, only one filter kernel is connected to external multiple data channels, the filter kernel is polled by data from different channels, and the use of the filter kernel by multiple signals is achieved by frequency dividing counters or switching counters.

Conventional solutions use the same one filter for different channels of data information, cannot take different filtering processes for different channels of data, and have large limitations; the time interval during which each set of data is received by the multi-channel digital filter is erroneous, resulting in loss of data when the filter is operating on the previous set of data as the current set of data is input.

### SUMMARY

The present invention provides a multi-channel filter data processing method, system, apparatus, device, and medium, which effectively solves the problem of data loss by pre-storing target data into registers and processing into different filter kernels depending on the filtering manner.

According to an aspect of the present invention, there is provided a data processing method of a multi-channel filter, comprising:
acquiring target data of multiple channels and corresponding filtering manners;
storing the target data into corresponding registers, respectively, based on the filtering manners; wherein a register corresponds to a filtering manner;
determining whether a filter kernel corresponding to a register is in an idle state; and
if the filter kernel is in the idle state, feeding the target data into the filter kernel to perform a filtering process.

Optionally, the method further comprises, before acquiring the target data of multiple channels and the corresponding filtering manners:
configuring filter kernel parameters corresponding to the filtering manner for the filter kernels of the respective channels, respectively; wherein the filter kernel parameters comprise an order and/or a coefficient.

Optionally, the determining whether the filter kernel to which the register corresponds is in the idle state comprises:
acquiring an operation signal corresponding to the filter kernel;
wherein if the operation signal is at a high level, the filter kernel is not in the idle state; and
if the operation signal is at a low level, the filter kernel is in the idle state.

Optionally, the method further comprises, after storing the target data into the registers, respectively:
setting a flag bit corresponding to the register to a first set value; and
when the target data is fed into the filter kernel, setting the flag bit of the register to a second set value.

Optionally, the filter kernel employs a multiplier; and the number of the filter kernels corresponds to the number of the filtering manners.

According to another aspect of the present invention, there is provided a data processing system for a multi-channel filter, comprising: a plurality of registers, the plurality of registers corresponding to a plurality of filter kernels, respectively;
wherein the plurality of registers are used to store target data of corresponding channels, respectively; wherein a register corresponds to a filtering manner corresponding to the target data; and
the filter kernel is configured to perform a filter process on input target data when the filter kernel is in an idle state.

According to another aspect of the invention, there is provided a data processing apparatus of a multi-channel filter, comprising:
a data acquisition module, configured to acquire multi-channels of target data and corresponding filtering manners;
a register storing module, configured to store the target data into corresponding registers, respectively, based on the filtering manners; wherein a register corresponds to a filtering manner;
a filter kernel state determination module configured to determine whether a filter kernel corresponding to a register is in an idle state;
and a filtering process module configured to feed the target data into the filter kernel to perform a filter process if the filter kernel is in the idle state.

Optionally, the method further comprises;
a filter kernel configuration module, configured to, before acquiring target data of multiple channels and corresponding filtering manners, respectively configure filter kernel parameters corresponding to the filtering manners for filter kernels of respective channels; wherein the filter kernel parameters comprise an order and/or a coefficient.

According to another aspect of the present invention, there is provided An electronic device, comprising:
at least one processor; And
a memory communicatively connected with the at least one processor; wherein,
the memory stores a computer program executable by the at least one processor, the computer program being executed by the at least one processor to enable the at least one processor to perform a data processing method of a multi-channel filter of any one of the embodiments of the present invention.

According to another aspect of the present invention, there is provided a computer-readable storage medium having stored thereon computer instructions which, when being executed by a processor, cause the processor to implement the data processing method of a multi-channel filter of any one of the embodiments of the present invention.

In the technical solution of an embodiment of the present invention, target data of multiple channels and corresponding filtering manners are acquired; the target data is stored into corresponding registers, respectively, based on the filtering manners; a register corresponding to a filtering manner; it is determined whether a filter kernel corresponding to a register is in an idle state; and if the filter kernel is in the idle state, the target data is fed into the filter kernel to perform a filtering process. The present solution can effectively solve the problem of data loss by pre-storing the target data in a register and feeding the target data into different filter kernels according to the filtering manner.

It should be understood that what is described in this section is not intended to identify key or critical features of embodiments of the invention nor is it intended to limit the scope of the invention. Other features of the present invention will become apparent from the following description.

### BRIEF DESCRIPTION OF THE DRAWINGS

In order to more clearly illustrate the technical solutions in the embodiments of the present invention, the following will simply introduce the accompanying drawings to be used in the description of the embodiments, and it is obvious that the accompanying drawings in the following description are only some embodiments of the present invention, and it will be obvious to those skilled in the art that other drawings can be obtained according to these drawings without inventive step.
Fig. 1 is a flowchart illustrating a data processing method of a multi-channel filter according to an embodiment of the present invention;
Fig. 2 is a flowchart of a data processing system of a multi-channel filter according to a second embodiment of the present invention;
Fig. 3 is an overall exemplary view of a digital filter chip provided according to the second embodiment of the present invention;
Fig. 4 is a block diagram of a data processing apparatus of a multi-channel filter according to a third embodiment of the present invention; and
Fig. 5 is a structural diagram of an electronic device according to a fourth embodiment of the present invention.

### DETAILED DESCRIPTION

In order for those skilled in the art to better understand the solutions of the present invention, the technical solutions of the embodiments of the present invention will be clearly and completely described below in conjunction with the accompanying drawings of the embodiments of the present invention, it is obvious that the described embodiments are only embodiments of a part of the present invention, rather than all of the embodiments. Based on the embodiments in the present invention, all other embodiments obtained by those of ordinary skill in the art without making inventive labor should belong to the scope of protection of the present invention.

It should be noted that the terms "first," "second," and "target," and the like in the description and claims of the present invention as well as in the drawings described above, are used for distinguishing between similar objects and not necessarily for describing a particular sequential or chronological order. It is to be understood that such use of data may be interchanged under appropriate circumstances such that the embodiments of the invention described herein are capable of being practiced in sequences other than those illustrated or described herein. Furthermore, the terms "comprises," "comprising," "has," "having," "the like," and any variations thereof, are intended to cover a non-exclusive inclusion, such that, for example, a process, method, system, article, or apparatus that comprises a list of steps or elements is not necessarily limited to those steps or elements expressly listed but may include other steps or elements not expressly listed or inherent to such process, method, article, or apparatus.

### First Embodiment

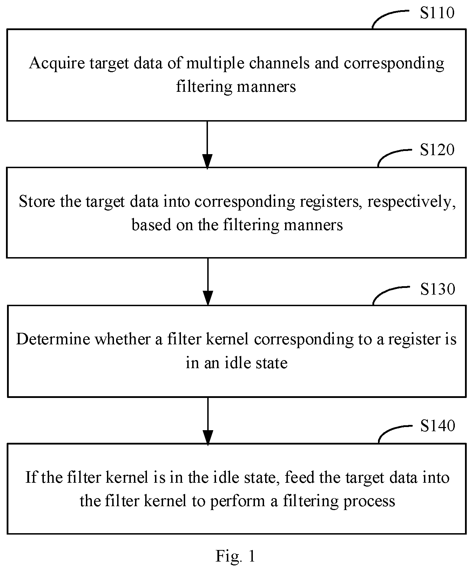

Fig. 1 is a flowchart of a data processing method of a multi-channel filter according to a first embodiment of the present invention, the embodiment being applicable to the case of processing data of a multi-channel filter, the method being executable by a data processing apparatus of the multi-channel filter, the data processing apparatus of the multi-channel filter being implemented in the form of hardware and/or software, the data processing apparatus of the multi-channel filter being configurable in an electronic device having a data processing capability. As shown in Fig. 1, the method includes the following steps.

This embodiment may be performed by the data processing system of the multi-channel filter. The present embodiment is directed to filtering data for a multi-channel synchronous sampling analog-to-digital data conversion system, providing a plurality of different configurable filter kernels in a multi-channel digital filter chip for filtering data of multiple channels.

At S110, target data of multiple channels and corresponding filtering manners are acquired.

Herein, target data may be understood as data of multiple channels acquired for a multi-channel synchronous sampling analog-to-digital data conversion system. The target data may be a digital signal. The pre-processing operation may be performed on the data collected in the conversion system in this embodiment. The analog signal can be converted into a digital signal through a data pre-processing operation. The manner of filtering may be understood as a desired filtering effect corresponding to the target data. The present embodiment may determine the corresponding filtering of the target data based on noise carried by the acquired target data of multiple channels, and the corresponding filtering is required to remove the noise. By way of example, the filtering may be high-pass, low-pass, band-pass, band-stop, all-pass, etc., and the filtering in the present embodiment may be determined according to actual requirements, and the present embodiment is not limited thereto. In this embodiment, the target data collected by the analog-to-digital data conversion system may be sampled synchronously with respect to multiple channels, and the filtering method corresponding to the acquisition of the target data.

In the present embodiment, optionally, before acquiring the target data of multiple channels and the corresponding filtering manners, the method further includes: configuring filter kernel parameters corresponding to the filtering manner for the filter kernels of the respective channels, respectively.

Herein, the filter kernel parameters may include an order and/or a coefficient. The filter kernel parameters may include the order or the coefficient of the filter kernel, and may also include the order and the coefficient of the filter kernel. The present embodiment may separately configure filter kernel parameters corresponding to filtering manners by the filter kernels for respective channels before acquiring target data of multiple channels and corresponding filtering manners. The filter kernel parameters may be configured in this embodiment to achieve the effect of different filtering manners.

With such an arrangement, the present embodiment can configure the order of each filter kernel and its system to achieve the effect of specific filtering of data of different channels.

At S120, the target data is stored into corresponding registers, respectively, based on the filtering manners.

Herein a register corresponds to a filtering manner. The registers in this embodiment may correspond to different filtering manners. The registers in this embodiment may correspond to different filter kernels. In this embodiment, the distribution of the target data for different channels may be stored in registers corresponding to different filter kernels based on the filtering manners corresponding to the target data.

In the present embodiment, optionally, after storing the target data into the registers respectively, the method further includes: setting a flag bit corresponding to the register to a first set value; and when the target data is fed into the filter kernel, setting the flag bit of the register to a second set value.

Herein, the first set value may be 1. The second set value may be 0. In the present embodiment, when the target data is stored in registers corresponding to different filter kernels, the flag bit corresponding to the register, that is, the flag bit corresponding to the register may be set to one. The flag position bit in this embodiment is understood to change from a low level to a high level. When a filter kernel corresponding to a register is in an idle state, the target data may be fed into the filter kernel for processing, and when the target data is fed into the corresponding filter kernel, the flag bit corresponding to the register may be set to a second set value. With such an arrangement in the present embodiment, the target data can be stored in advance in the respective register when the filter kernel is not idle, and the state of the register can be determined, effectively solving the problem of data loss.

At S130, it is determined whether a filter kernel corresponding to a register is in an idle state.

Here, the idle state can be understood as that no arithmetic processing is performed in the filter kernel corresponding to the register. The state of the filter kernel may be determined based on an operation signal to which the filter kernel corresponds in this embodiment. In this embodiment, it is possible to determine whether the filter kernel corresponding to the register handles the idle state based on the operation signal of the filter kernel.

In this embodiment, optionally, the filter kernel employs a multiplier; and the number of filter kernels corresponds to the number of filtering manners.

The filter kernels in this embodiment can be extended by using one multiplier to make the filter's filtering time longer. The number of filter kernels in this embodiment may correspond to the number of filtering manners, and the number of specific filter kernels may be determined based on the number of filtering manners of the target data. Exemplarily, the filter kernels in this embodiment may be eight. With such an arrangement in this embodiment, fewer multipliers are used per filter kernel, saving hardware resources.

In the present embodiment, optionally, the determining whether the filter kernel corresponding to the register is in the idle state includes: acquiring an operation signal corresponding to the filter kernel; if the operation signal is at a high level, the filter kernel is not in the idle state; and if the operation signal is at a low level, the filter kernel is in the idle state.

Herein, the operation signal may be used to determine whether the filter kernel is in the idle state. In the present embodiment, when target data is fed into the filter kernel for operation, the filter kernel sends an operation signal, and the operation signal is at a high level, indicating that the operation is being performed at this time; the operation signal is also issued when the operation of the target data in the filter kernel is completed, and the operation signal is at a low level indicating that the operation of the filter kernel is completed.

In this embodiment, the operation signal corresponding to each filter kernel can be obtained, and if the operation signal is at a high level, the current filter kernel is in operation, and the filter kernel is not in the idle state; if the operation signal is at a low level, the current filter kernel is not operating, and the filter kernel is idle. With this arrangement in the present embodiment, the corresponding state of the current filter kernel can be determined by the operation signal, and when the filter kernel is not in the idle state, data can be prestored in the register unit, and the problem of data loss caused by too fast a sampling frequency of the multi-channel synchronous sampling analog-to-digital data conversion system is prevented.

At S 140, if the filter kernel is in the idle state, the target data is fed into the filter kernel to perform a filtering process.

In this embodiment, it is determined that the filter kernel is in the idle state by judging the operation signal, and the target data can be fed into the filter kernel to perform a filtering process.

In the technical solution of an embodiment of the present invention, target data of multiple channels and corresponding filtering manners are acquired; the target data is stored into corresponding registers, respectively, based on the filtering manners; a register corresponding to a filtering manner; it is determined whether a filter kernel corresponding to a register is in an idle state; and if the filter kernel is in the idle state, the target data is fed into the filter kernel to perform a filtering process. The present solution can effectively solve the problem of data loss by pre-storing the target data in a register and feeding the target data into different filter kernels according to the filtering manner.

### Second Embodiment

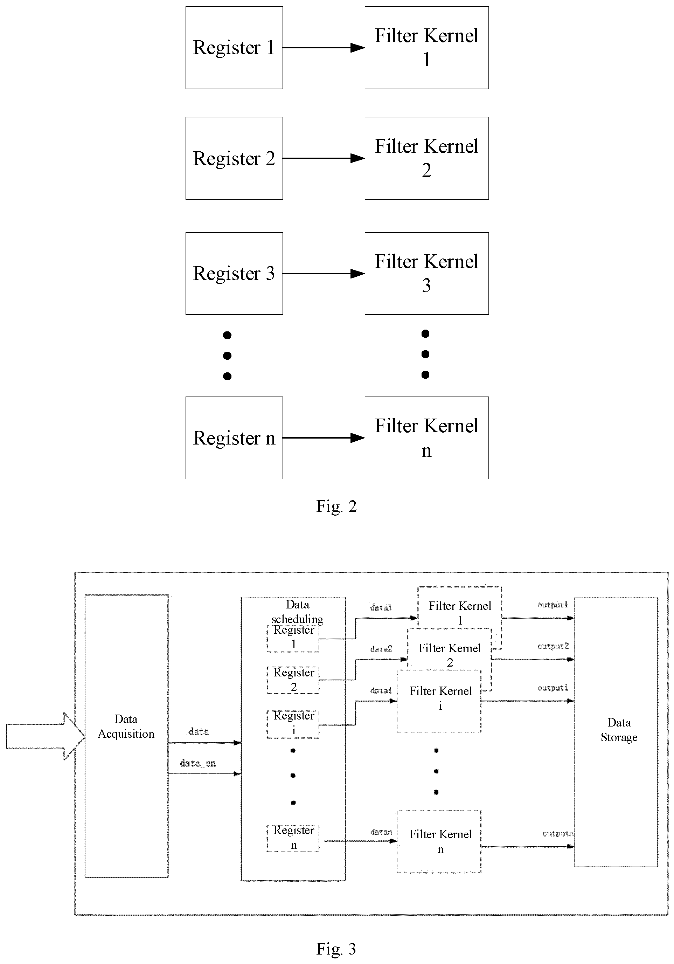

Fig. 2 is a flowchart of a data processing system of a multi-channel filter according to a second embodiment of the present invention. As shown in Fig. 2, the system includes a plurality of registers, and the plurality of registers correspond to a plurality of filter kernels, respectively. As shown in Fig. 2, a register 1 corresponds to a filter kernel 1, a register 2 corresponds to a filter kernel 2, a register 3 corresponds to a filter kernel 3, and so on, and a register n corresponds to a filter kernel n.

The data processing system of a multi-channel filter of the present embodiment can be used to perform the data processing method of a multi-channel filter.

A plurality of registers are used to store target data of corresponding channels, respectively; herein a register corresponds to a filtering manner, and a filtering manner corresponds to the target data.

The data processing system of the multi-channel filter in the present embodiment may store target data of different channels in a corresponding plurality of registers, respectively.

The filter kernel is used to perform a filtering process on input target data when the filter kernel is in an idle state.

The filter kernel of the data processing system of the multi-channel filter in the present embodiment may filter the input target data while being in the idle state.

Exemplarily, an overall example diagram of the digital filter chip in this embodiment is shown in Fig. 3. Herein, the data and data_ en signals may be signals for transmitting target data from data acquisition to the chip, data_ en representing a data enable signal and data representing a data signal. Datal, data2, datai, and datan correspond to corresponding stored target data in the register 1, the register 2, the register i, and the register n, respectively, and are fed to the corresponding filter kernel 1, the filter kernel 2, the filter kernel i, and the filter kernel n, respectively, and output data from different filter kernels through output, and the output filtered data are stored.

In an aspect of an embodiment of the present invention, a data processing system of a multi-channel filter includes a plurality of registers, and the plurality of registers correspond to a plurality of filter kernels, respectively. A plurality of registers are used to store target data of corresponding channels, respectively; the filter kernels are used to filter the input target data while in the idle state, and the target data can be pre-stored in registers and fed into different filter kernels according to the filtering manners, thereby effectively solving the problem of data loss.

### Third Embodiment

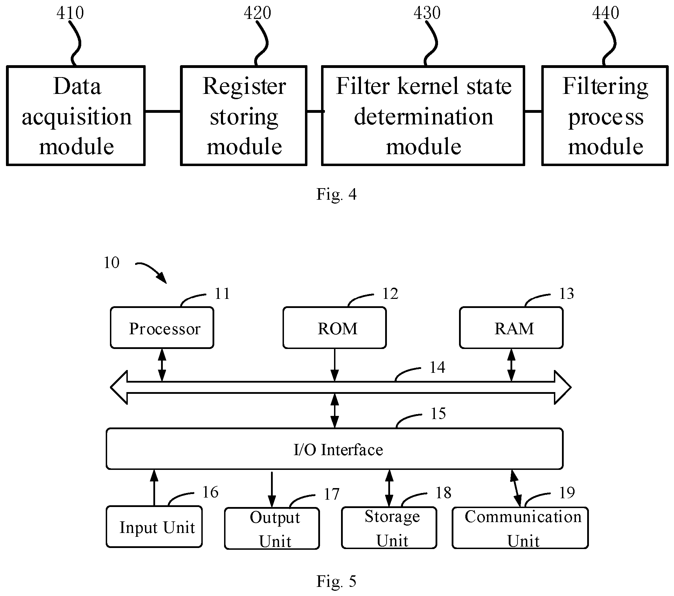

Fig. 4 is a block diagram of a data processing apparatus of a multi-channel filter according to a third embodiment of the present invention. As shown in Fig. 4, the apparatus includes the following modules.

A data acquisition module 410 is configured to acquire target data of multiple channels and corresponding filtering manners.

A register storing module 420 is configured to store the target data into corresponding registers, respectively, based on the filtering manners; herein a register corresponds to a filtering manner.

A filter kernel state determination module 430 is configured to determine whether the filter kernel corresponding to the register is in an idle state.

And a filtering process module 440 is configured to feed the target data into the filter kernel to perform a filter process if the filter kernel is in the idle state.

Optionally, the apparatus further includes the following modules.

A filter kernel configuration module is configured to respectively configure filter kernel parameters corresponding to filtering manners for filter kernels of respective channels before acquiring target data of multiple channels and corresponding filtering manners; herein the filter kernel parameters include an order and/or a coefficient.

Optionally, the filter kernel state judgment module 430 is specifically configured to acquire an operation signal corresponding to the filter kernel; herein if the operation signal is at a high level, the filter kernel is not in the idle state; if the operation signal is at a low level, the filter kernel is in the idle state.

Optionally, a register flag bit setting module is configured to set a corresponding flag bit of the register to a first set value after storing the target data into the register respectively.

When the target data is fed into the filter kernel, the flag bit of the register is set to a second set value.

Optionally, the filter kernel employs a multiplier; and the number of filter kernels corresponds to the number of filtering manners.

The apparatus for processing a data of a multi-channel filter according to an embodiment of the present invention can execute a method for processing a data of a multi-channel filter according to any embodiment of the present invention, with functional blocks and advantageous effects corresponding to the execution of the method.

### Fourth Embodiment

Fig. 5 is a structural diagram of an electronic device according to a fourth embodiment of the present invention. The electronic device 10 is intended to represent various forms of digital computers, such as laptops, desktops, workstations, personal digital assistants, servers, blade servers, mainframes, and other appropriate computers. The electronic device may also represent various forms of mobile devices, such as personal digital processing, cellular telephones, smart phones, wearable devices (e.g., helmets, glasses, watches, etc.), and other similar computing devices. The components shown here, their connections and relationships, and their functions, are by way of example only, and are not meant to limit implementations of the inventions described and/or claimed in this document.

As shown in Fig. 5, the electronic device 10 includes at least one processor 11, and a memory, such as a read-only memory (ROM) 12, a random access memory (RAM) 13, etc., communicatively connected with the at least one processor 11, herein the memory stores a computer program executable by the at least one processor, The processor 11 may perform various appropriate actions and processes in accordance with a computer program stored in a read only memory (ROM) 12 or loaded into a random access memory (RAM) 13 from a storage unit 18. In the RAM 13, various programs and data required for the operation of the electronic device 10 may also be stored. The processor 11, ROM 12 and RAM 13 are connected to each other by a bus 14. An input/output (I/O) interface 15 is also connected to the bus 14.

A number of components in the electronic device 10 are connected to the I/O interface 15, including: an input unit 16, such as a keyboard, a mouse, or the like; an output unit 17 such as various types of displays, speakers, and the like; a storage unit 18, e.g., magnetic disk, optical disk, etc.; and a communication unit 19, such as a network card, a modem, a wireless communication transceiver, or the like. The communication unit 19 allows the electronic device 10 to exchange information/data with other devices over a computer network such as the Internet and/or various telecommunication networks.

The processor 11 may be various general purpose and/or special purpose processing components with processing and computing capabilities. Some examples of the processor 11 include, but are not limited to, a central processing unit (CPU), a graphics processing unit (GPU), various specialized artificial intelligence (AI) computing chips, various processors running machine learning model algorithms, a digital signal processor (DSP), and any suitable processor, controller, microcontroller, or the like. The processor 11 performs the various methods and processes described above, such as the data processing method of the multi-channel filter.

In some embodiments, the data processing method of the multi-channel filter may be implemented as a computer program tangibly embodied on a computer readable storage medium, such as the storage unit 18. In some embodiments, part or all of the computer program may be loaded into and/or installed onto electronic device 10 via ROM 12 and/or communication unit 19. When the computer program is loaded into the RAM 13 and executed by the processor 11, one or more steps of the data processing method of a multi-channel filter described hereinabove may be performed. Alternatively, in other embodiments, the processor 11 may be configured in any other suitable way, e.g. by means of firmware, to perform the data processing method of the multi-channel filter.

Various implementations of the systems and techniques described above can be realized in digital electronic circuitry, integrated circuitry, field programmable gate arrays (FPGA), application specific integrated circuits (ASIC), application specific standard products (ASSP), system-on-a-chip systems (SOC), load programmable logic devices (CPLD), computer hardware, firmware, software, and/or combinations thereof. These various implementations can include implementation in one or more computer programs that are executable and/or interpretable on a programmable system including at least one programmable processor, which may be special or general purpose, that may receive data and instructions from, and to transmit data and instructions to, a storage system, at least one input device, and at least one output device.

Computer programs for carrying out methods of the present invention may be written in any combination of one or more programming languages. These computer programs may be provided to a processor of a general purpose computer, special purpose computer, or other programmable data processing apparatus, such that the computer programs, when executed by the processor, cause the functions/operations specified in the flowcharts and/or block diagrams to be implemented. The computer program may execute entirely on the machine, partly on the machine, partly on the machine and partly on a remote machine as a stand-alone software package or entirely on the remote machine or server.

In the context of the present invention, a computer readable storage medium may be a tangible medium that can contain, or store a computer program for use by or in connection with an instruction execution system, apparatus, or device. A computer readable storage medium may include, but is not limited to, an electronic, magnetic, optical, electromagnetic, infrared, or semiconductor system, apparatus, or device, or any suitable combination of the foregoing. Alternatively, the computer readable storage medium may be a machine readable signal medium. More specific examples of the machine readable storage medium would include an electrical connection based on one or more wires, a portable computer diskette, a hard disk, a random access memory (RAM), a read-only memory (ROM), an erasable programmable read-only memory (EPROM or Flash memory), an optical fiber, a convenient compact disc read-only memory (CD-ROM), an optical storage device, a magnetic storage device, or any suitable combination of the foregoing.

To provide for interaction with a user, the systems and techniques described here can be implemented on an electronic device having a display device (e.g., a CRT (cathode ray tube) or LCD (liquid crystal display) monitor) for displaying information to the user; And a keyboard and a pointing device (e.g., a mouse or a trackball) by which a user may provide input to an electronic device. Other kinds of devices can be used to provide for interaction with a user as well; For example, feedback provided to the user can be any form of sensory feedback (e.g., visual feedback, auditory feedback, or tactile feedback); And input from the user can be received in any form, including acoustic, speech, or tactile input.

The systems and techniques described here may be implemented in a computing system that includes a back-end component (e.g., as a data server), or that includes a middleware component (e.g., an application server), or that includes a front-end component (e.g., as a data server) A user computer having a graphical user interface or a Web browser through which a user can interact with an implementation of the systems and techniques described here), or a computing system that includes any combination of such back end, middleware, or front end components. The components of the system can be interconnected by any form or medium of digital data communication, e.g., a communication network. Examples of communication networks include a local area network (LAN), a wide area network (WAN), blockchain networks, and the Internet.

The computing system can include clients and servers. A client and server are generally remote from each other and typically interact through a communication network. The relationship of client and server arises by virtue of computer programs running on the respective computers and having a client-server relationship to each other. The server may be a cloud server, also referred to as a cloud computing server or a cloud host, and is a host product in a cloud computing service architecture to address the drawbacks of the traditional physical host and VPS services that are difficult to manage and have weak business scalability.

It should be understood that various forms of the flow shown above may be used, with steps reordered, added, or deleted. For example, each step described in the present invention may be executed in parallel, may be executed sequentially, or may be executed in a different order, which is not limited herein as long as the desired result of the technical solution of the present invention can be achieved.

The above detailed description is not to be construed as limiting the scope of the present invention. It should be apparent to those skilled in the art that various modifications, combinations, sub-combinations, and substitutions may occur depending on design requirements and other factors. It is intended that all such modifications, equivalents, and improvements be included within the spirit and scope of the invention.

## Claims

1. A data processing method of a a multi-channel filter, comprising:
acquiring target data of multiple channels and corresponding filtering manners;
storing the target data into corresponding registers, respectively, based on the filtering manners; wherein a register corresponds to a filtering manner;
determining whether a filter kernel corresponding to a register is in an idle state; and
if the filter kernel is in the idle state, feeding the target data into the filter kernel to perform a filtering process.

2. The method of claim 1, further comprising, before acquiring the target data of multiple channels and the corresponding filtering manners:
configuring filter kernel parameters corresponding to the filtering manner for filter kernels of respective channels, respectively; wherein the filter kernel parameters comprise an order and/or a coefficient.

3. The method of claim 1, wherein the determining whether the filter kernel to which the register corresponds is in the idle state comprises:
acquiring an operation signal corresponding to the filter kernel;
wherein if the operation signal is at a high level, the filter kernel is not in the idle state; and
if the operation signal is at a low level, the filter kernel is in the idle state.

4. The method of claim 1, further comprising, after storing the target data into the registers, respectively:
setting a flag bit corresponding to the register to a first set value; and
when the target data is fed into the filter kernel, setting the flag bit of the register to a second set value.

5. The method of claim 1, wherein the filter kernel employs a multiplier; and the number of the filter kernels corresponds to the number of the filtering manners.

6. A data processing system for a multi-channel filter, comprising: a plurality of registers, the plurality of registers corresponding to a plurality of filter kernels, respectively;
wherein the plurality of registers are used to store target data of corresponding channels, respectively; wherein a register corresponds to a filtering manner corresponding to the target data; and
the filter kernel is configured to perform a filtering process on the inputted target data when the filter kernel is in an idle state.

7. A data processing apparatus of a a multi-channel filter, comprising:
a data acquisition module, configured to acquire target data of multiple channels and corresponding filtering manners;
a register storing module, configured to store the target data into corresponding registers, respectively, based on the filtering manners; wherein a register corresponds to a filtering manner;
a filter kernel state determination module, configured to determine whether a filter kernel corresponding to a register is in an idle state; and
a filtering process module, configured to feed the target data into the filter kernel to perform a filter process process if the filter kernel is in the idle state.

8. The apparatus of claim 7, further comprising;
a filter kernel configuration module, configured to, before acquiring the target data of the multiple channels and the corresponding filtering manners, configure filter kernel parameters corresponding to the filtering manners for filter kernels of respective channels, respectively; wherein the filter kernel parameters comprise an order and/or a coefficient.

9. An electronic device, comprising:
at least one processor; and
a memory communicatively connected with the at least one processor; wherein,
the memory stores a computer program executable by the at least one processor, the computer program being executed by the at least one processor to enable the at least one processor to perform the data processing method of a a multi-channel filter of any one of claims 1-5.

10. A computer-readable storage medium having stored thereon computer instructions, which, when being executed by a processor, cause the processor to implement the data processing method of a a multi-channel filter of any one of claims 1-5.
